Europäisches Patentamt

European Patent Office

Office européen des brevets

(11) Veröffentlichungsnummer: **0 210 124 B1**

# EUROPÄISCHE PATENTSCHRIFT

(45) Veröffentlichungstag der Patentschrift: **12.06.91**

(51) Int. Cl.⁵: **H03L 7/14**, H03L 7/16

(21) Anmeldenummer: **86730108.7**

(22) Anmeldetag: **14.07.86**

(54) **Verfahren zum Kalibrieren eines einstellbaren Frequenzgenerators.**

(30) Priorität: **19.07.85 DE 3526363**

(43) Veröffentlichungstag der Anmeldung:
**28.01.87 Patentblatt 87/05**

(45) Bekanntmachung des Hinweises auf die Patenterteilung:
**12.06.91 Patentblatt 91/24**

(84) Benannte Vertragsstaaten:
**AT BE CH DE FR GB IT LI NL**

(56) Entgegenhaltungen:
**EP-A- 0 041 882**
**DE-A- 3 411 883**
**FR-A- 2 535 545**
**GB-A- 2 122 822**
**US-A- 4 103 250**

(73) Patentinhaber: **Siemens Aktiengesellschaft**
**Wittelsbacherplatz 2**
**W-8000 München 2(DE)**

(72) Erfinder: **Vollmer, Hans-Ulrich, Dipl.-Ing.**
**Didostrasse 14c**
**W-1000 Berlin 42(DE)**

## Beschreibung

Es sind einstellbare Frequenzgeneratoren mit einem spannungs-gesteuerten Oszillator bekannt. Beispielsweise in dem Buch von U. Tietze, Ch. Schenk "Halbleiter-Schaltungstechnik", 4. Auflage, 1978, Seiten 440 und 441 ist ein spannungsgesteuerter Oszillator beschrieben, dessen Ausgangsfrequenz der Eingangsspannung proportional ist. Nicht nur dieser bekannte spannungsgesteuerte Oszillator, sondern Oszillatoren dieser Art allgemein weisen eine nichtlineare Steuerkennlinie auf; dies bedeutet, daß sich die Frequenz nichtlinear mit der Eingangs-größe ändert. Deshalb ist eine Kalibrierung der spannungsge-steuerten Oszillatoren erforderlich.

Dies gilt auch für einen einstellbaren Frequenzgenerator, wie er in der US-PS 41 03 250 beschrieben ist. Dieser bekannte Frequenzgenerator enthält einen spannungsgesteuerten Oszillator, dem über einen Digital-Analog-Umsetzer ein ROM vorgeordnet ist, das Bestandteil eines Rechners sein kann. Bei Anwahl einer Frequenz wird über das ROM unter Berücksichtigung der nichtlinearen Kennlinie des spannungsgesteuerten Oszillators mittels des nachgeordneten Digital-Analog-Umsetzers der Oszillator mit einer derartigen Eingangsspannung beaufschlagt, daß er ausgangsseitig die angewählte Frequenz erzeugt. Mittels eines RAM und einer elektronischen Zusatzeinrichtung kann die Genauigkeit in der Frequenzerzeugung verbessert werden.

Es ist ferner ein einstellbarer Frequenzgenerator bekannt (FR-A-2 535 545), dessen Oszillator mit seinem Ausgang über einen Frequenzteiler mit einem Eingang eines Phasenkomparators verbunden ist. Ein weiterer Eingang des Phasenkomparators ist mit einer Referenzfrequenz beaufschlagt. Der Ausgang des Phasenkomparators ist über einen Schalter mit einem Integrator verbunden, der ausgangsseitig mit dem Eingang des Oszillators verbunden ist und über einen Umschalter mit dem Eingang eines Analog-Digital-Umsetzers oder mit dem Ausgang eines Digital-Analog-Umsetzers verbindbar ist. Beide Umsetzer sind Bestandteile der Speicheranordnung, mit der der Oszillator bei aufgetrennter Schleife unter Beibehaltung seiner Frequenz gesteuert werden kann.

Der Erfindung liegt die Aufgabe zugrunde, ein Verfahren zum Kalibrieren eines einstellbaren Frequenzgenerators der eingangs beschriebenen Art anzugeben, also eines Frequenzgenerators, bei welchem dem spannungsgesteuerten Oszillator über einen Digital-Analog-Umsetzer ein Rechner vorgeordnet ist.

Zur Lösung dieser Aufgabe wird erfindungsgemäß dem Oszillator eine Kalibriereinrichtung mit einer Reihenschaltung aus einem digitalen Phasendetektor und einem Tiefpaß unter Bildung eines Phase-locked loop-Schaltungsaufbaus vorgeordnet, indem der Ausgang des Oszillators mit einem Eingang des Phasendetektors und ein weiterer Eingang des Phasendetektors mit einem einstellbaren Frequenz-Sollwertgeber der Kalibriereinrichtung verbunden wird, und es werden dem Rechner digitale Sollwertsignale entsprechend verschiedenen Frequenz-Sollwert-signalen an dem weiteren Eingang des Phasendetektors zugeführt; von dem Rechner wird nach Erreichen des eingeschwungenen Zustandes des Phase-locked loop-Schaltungsaufbaus auf das jeweilige Frequenz-Sollwertsignal hin die Ausgangsspannung des Digital-Analog-Umsetzers als Steuerspannung für den Oszillator geändert, bis sie der Ausgangsspannung des Tiefpasses vor Beginn des Kalibriervorganges entspricht, und ein der Steuerspannung entsprechender Digitalwert wird dem jeweiligen digitalen Sollwertsignal zugeordnet im Rechner gespeichert sowie der Eingang des Oszillators unter Bildung des einstellbaren Frequenzgenerators von der Kalibriereinrichtung abgetrennt.

Durch den Einsatz der Kalibriereinrichtung wird für jede mittels der Kalibriereinrichtung eingestellte Frequenz mittels des Rechners von dem Digital-Analog-Umsetzer eine Steuerspannung gebildet, die den spannungsgesteuerten Oszillator zur Abgabe eines Signals mit einer definierten Ausgangsfrequenz veranlaßt, wobei diese Ausgangsfrequenz aufgrund des Phase-locked loop-Schaltungsaufbaus direkt dem jeweiligen Frequenz-Sollwert entspricht. Durch die Speicherung eines der jeweiligen Steuerspannung entsprechenden Digitalwertes zusammen mit dem digitalen Sollwertsignal im Speicher des Rechners ist dann sichergestellt, daß bei einer Anwahl einer gewünschten Frequenz im Rechner der erfindungsgemäße Frequenzgenerator am Ausgang seines spannungsgesteuerten Oszillators tatsächlich diese Frequenz erzeugt. Dies geschieht ohne Zeitverzögerung, da ein Einschwingen des erfindungsgemäßen Frequenzgenerators nicht eintritt. Somit kann der erfindungsgemäße Frequenzgenerator in vorteilhafter Weise im Start-Stop-Betrieb arbeiten, also auf einen vorgegebenen Befehl hin sofort eine Schwingung mit einer gewünschten Frequenz und einer definierten Anfangsbedingung an seinem Ausgang hervorbringen.

Der Aufwand bei der Kalibrierung des erfindungsgemäßen Frequenzgenerators ist dabei verhältnismäßig gering, weil zur Kalibriereinrichtung gängige phasenverriegelte Frequenzgeneratoren Verwendung finden können, beispielsweise ein einstellbarer, phasenverriegelter Frequenzgenerator, wie er in der DE-OS 34 11 883 beschrieben ist. Auch der Phase-locked loop-Schaltungsaufbau verursacht keinen hohen Aufwand. Hinsichtlich des Zeitaufwandes beim Kalibrieren des erfindungsgemäßen Frequenzgenerators ist anzuführen, daß der erfindungsgemäße Frequenzgenerator diesbezüglich besonders vorteilhaft ist, weil jeweils nach Vorgabe eines bestimmten Frequenz-Sollwertes durch die Kalibriereinrichtung die Gewinnung der Steuerspannung und die Speicherung des der jeweiligen Frequenz entsprechenden digitalen Sollwertsignals und eines der Steuerspannung entsprechenden Digitalwertes im Rechner selbsttätig erfolgt.

Das erfindungsgemäße Verfahren kann hinsichtlich der Erzeugung der Steuerspannung in unterschiedlicher Weise abgewickelt werden. So wird es als vorteilhaft angesehen, wenn der Ausgang des Digital-Analog-Umsetzers über eine Summierschaltung mit dem Eingang des spannungsgesteuerten Oszillators verbunden wird, die Ausgangsspannung des Tiefpasses auf das Erreichen des Wertes Null überwacht wird und beim Wert Null ein Speicherbefehl für das jeweilige digitale Sollwertsignal und den der Steuerspannung entsprechenden Digitalwert erzeugt wird.

Es kann auch vorteilhaft sein, wenn bei einer anderen Art des erfindungsgemäßen Verfahrens der Ausgang des Digital-Analog-Umsetzer über eine Summierschaltung mit dem Eingang des spannungsgesteuerten Oszillators verbunden und eine Kalibriereinrichtung mit einem Phasendetektor mit zwei Ausgängen verwendet wird, dessen beiden Ausgangssignale auf Phasengleichheit untersucht werden; bei Phasengleichheit wird ein Speicherbefehl für das digitale Frequenz-Sollsignal und den der Steuerspannung entsprechenden Digitalwert erzeugt. Bei dieser Verfahrensart darf jedoch der Tiefpaß keine integrierende Wirkung haben.

Bei einer weiteren vorteilhaften Form des erfindungsgemäßen Verfahrens wird der Ausgang des Digital-Analog-Umsetzers mit einem nicht belegten Kontakt eines Schalters verbunden, dessen weiterer belegter Kontakt den spannungsgesteuerten Oszillator mit dem Tiefpaß verbindet; in dem eingeschwungenen Zustand wird die Ausgangsspannung des Digital-Analog-Umsetzers mit der Ausgangsspannung des Tiefpasses verglichen und bei Spannungsgleichheit als die Steuerspannung erkannt, und es wird bei Spannungsgleichheit ein Speicherbefehl für das digitale Sollwertsignal und den der Steuerspannung entsprechenden Digitalwert erzeugt.

Das erfindungsgemäße Verfahren kann in seinen unterschiedlichen Ausführungsformen mit entsprechend unterschiedlich ausgebildeten Schaltungsanordnungen durchgeführt werden. So wird es zur Durchführung des Verfahrens mit einer Überwachung der Ausgangsspannung des Tiefpasses auf den Wert Null als vorteilhaft angesehen, daß der Frequenz-Sollwertgeber einerseits mit einem Adreß- und einem Datenbus des Rechners und andererseits mit dem weiteren Eingang des Phasendetektors verbunden ist, daß eine Spannungsüberwachungs-Schaltung der Kalibriereinrichtung eingangsseitig mit dem Ausgang des Tiefpasses und ausgangsseitig mit dem Adreß- und dem Datenbus des Rechners verbunden ist und daß der Digital-Analog-Umsetzer eingangsseitig an dem Adreß- und dem Datenbus des Rechners und ausgangsseitig mit der Summierschaltung verbunden ist. Die Spannungsüberwachungs-Schaltung kann als sogenannter Fensterkomperator ausgebildet sein, also beispielsweise so ausgeführt sein, wie es in dem bereits erwähnten Buch von Tietze/Schenk auf Seite 413 beschrieben ist. Mit einem solchen Fensterkomperator läßt sich dann nicht nur die Ausgangsspannung des Tiefpasses auf den Wert Null überwachen, sondern auch das Vorzeichen miterfassen.

Zur Durchführung des erfindungsgemäßen Verfahrens mit einer Kalibriereinrichtung mit Phasendetektor mit zwei Ausgängen ist bei einer Schaltungsanordnung zur Durchführung dieser Verfahrensart der Frequenz-Sollwertgeber vorteilhafterweise einerseits mit einem Adreß- und einem Datenbus des Rechners und andererseits mit dem weiteren Eingang des Phasendetektors verbunden und an den Ausgängen des Phasendetektors ist eingangsseitig eine digitale Impuls-Überwachungseinrichtung der Kalibriereinrichtung angeschlossen, die ausgangsseitig mit dem Adreß- und dem Datenbus des Rechners verbunden ist; der Digital-Analog-Umsetzer ist eingangsseitig an dem Adreß- und dem Datenbus des Rechners und ausgangsseitig mit der Summierschaltung verbunden, die über einen Schalter auch mit dem Ausgang des Tiefpasses verbindbar ist. Mit dieser Schaltungsanordnung erfolgt also die Kalibrierung unter digitaler Auswertung der Ausgangsimpulse des Phasendetektors.

Zur Durchführung des erfindungsgemäßen Verfahrens mit einem Schalter zwischen Digital-Analog-Umsetzer und dem spannungsgesteuerten Oszillator ist der Frequenz-Sollwertgeber vorteilhafterweise einerseits mit einem Adreß- und einem Datenbus des Rechners und andererseits mit dem weiteren Eingang des Phasendetektors verbunden, der Digital-Analog-Umsetzer eingangsseitig an dem Adreß- und dem Datenbus des Rechners und ausgangsseitig über den Schalter an dem Eingang des der Kalibriereinrichtung nachgeordneten Oszillators angeschlossen; ein Komparator der Kalibriereinrichtung ist eingangsseitig sowohl mit dem Ausgang des Digital-Analog-Umsetzers als auch mit dem Ausgang des Tiefpasses und ausgangsseitig mit dem Adreß- und Datenbus des Rechners verbunden. Ein wesentlicher Vorteil dieser Schaltungsanordnung besteht darin, daß während des einzelnen Kalibriervorganges mit einhergehender Änderung der Steuerspannung nicht der Phase-locked loop-Schaltungsaufbau beeinflußt wird, so daß ein erneutes Einschwingen dieses Aufbaues nicht eintritt und beim Kalibrieren nicht abgewartet werden muß.

Die erfindungsgemäßen Schaltungsanordnungen zeichnen sich durch die vorteilhafte Eigenschaft aus, als Frequenzgeneratoren im Start-Stop-Betrieb eingesetzt werden zu können und somit auf ein den spannungsgesteuerten Oszillator bzw. seinen Ausgang freigebendes Signal hin ohne Zeitverzögerung durch Einschwingvorgänge ein Signal mit der gewünschten Frequenz und definierter Anfangsbedingung (z.B. Nulldurchgang) an ihrem Ausgang zu erzeugen.

Wird angestrebt, die erfindungsgemäßen Schaltungsanordnungen nicht nur im Start-Stop-Betrieb zu betreiben, sondern einen kontinuierlichen Betrieb zu bewirken, dann ist der Oszillator über den jeweiligen Schalter mit dem Ausgang der Kalibriereinrichtung zu verbinden.

Zur Erläuterung der Erfindung ist in

Fig. 1 ein Ausführungsbeispiel einer Schaltungsanordnung zur Durchführung des erfindungsgemäßen Verfahrens mit Kalibriereinrichtung mit einem Fensterkomparator, in

Fig. 2 ein weiteres Ausführungsbeispiel der Schaltungsanordnung zur Durchführung des erfindungsgemäßen Verfahrens mit einer Kalibriereinrichtung mit einem Phasenkomparator mit zwei Ausgängen und in

Fig. 3 ein zusätzliches Ausführungsbeispiel der Schaltungsanordnung zur Durchführung des erfindungsgemäßen Verfahrens mit einer Kalibriereinrichtung mit einem Komparator wiedergegeben.

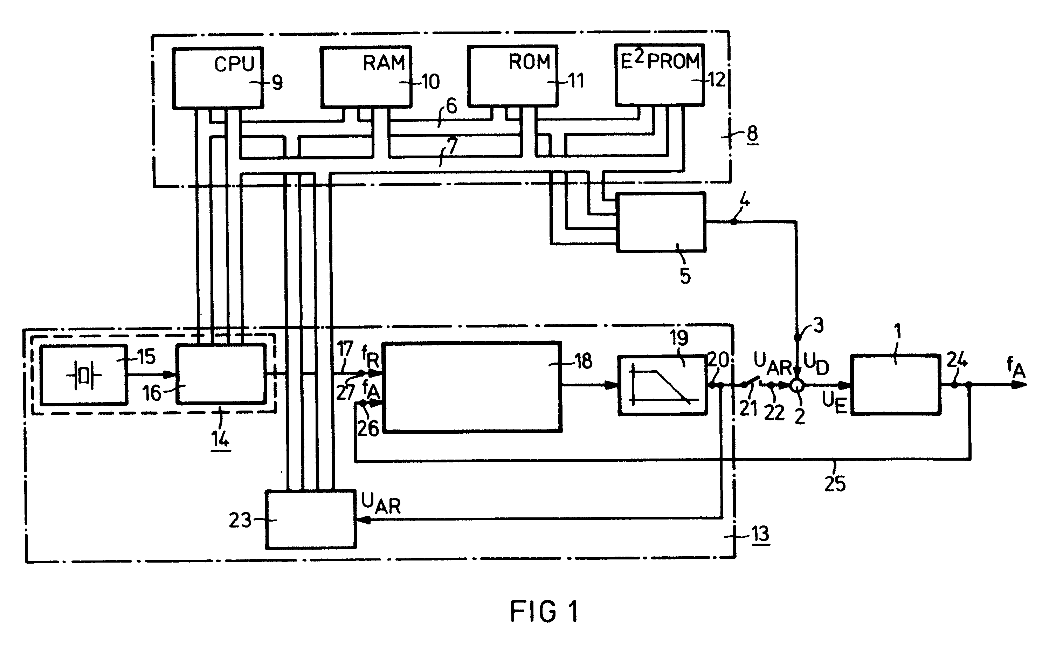

Die in Fig. 1 dargestellte Schaltungsanordnung zur Durchführung des erfindungsgemäßen Verfahrens enthält einen spannungsgesteuerten Oszillator 1, dem eine Summierschaltung 2 vorgeordnet ist. An einem Eingang 3 der Summierschaltung 2 ist ein Ausgang 4 eines Digital-Analog-Umsetzers 5 angeschlossen, der eingangsseitig sowohl mit einem Adreßbus 6 als auch mit einem Datenbus 7 eines Rechners 8 verbunden ist. Der Rechner 8 enthält eine Zentraleinheit 9, ein RAM 10, ein ROM 11 sowie einen nichtflüchtiges $E^2$PROM 12.

Dem Aufbau aus Rechner 8, Digital-Analog-Umsetzer 5 und spannungsgesteuertem Oszillator 1 ist eine Kalibriereinrichtung 13 zugeordnet, die unter anderem einen Frequenz-Sollwertgeber 14 enthält. Der Frequenz-Sollwertgeber 14 kann im einzelnen so aufgebaut sein, wie es in der DE-OS 34 11 883 beschrieben ist. Der Frequenz-Sollwertgeber 14 enthält demzufolge einen Referenzoszillator 15 und einen Frequenzsynthesizer 16. Der Frequenzsynthesizer 16 ist einerseits sowohl mit dem Adreßbus 6 als auch mit dem Datenbus 7 verbunden und steht andererseits über einen Verbindungsleitung 17 mit einem digitalen Phasendetektor 18 in Verbindung. Dem Phasendetektor 18, der so ausgebildet sein kann, wie es in dem Buch von Tietze/Schenk auf Seite 692 angegeben ist, ist ein Tiefpaß 19 nachgeordnet, dessen Ausgang 20 über einen Schalter 21 an einen Eingang 22 der Summierschaltung 2 angeschlossen ist. Außerdem ist der Ausgang 20 des Tiefpasses 19 mit einem Fensterkomparator 23 verbunden, der so ausgeführt sein kann, wie dies in dem oben bereits erwähnten Buch von Tietze/Schenk auf Seite 413 beschrieben ist. Der

Fensterkomparator 23 ist ausgangsseitig ebenfalls mit dem Adreßbus 6 und dem Datenbus 7 des Rechners 8 verbunden.

Zum Aufbau eines Phase-locked loop-Schaltungsaufbaues ist der Ausgang 24 des spannungsgesteuerten Oszillators 1 über eine Leitung 25 mit einem Eingang 26 des Phasendetektors 18 verbunden, an dessen weiterem Eingang 27 die Verbindungsleitung 17 vom Frequenz-Sollwertgeber 14 geführt ist.

Nachfolgend soll anhand der Fig. 1 das erfindungsgemäße Verfahren zur Herstellung eines einstellbaren Frequenzgenerators beschrieben werden.

Im geschlossenen Zustand des Schalters 21 wird am Frequenzsollwertgeber 14 eine Referenzfrequenz $f_R$ eingestellt, die in Form entsprechender Impulse an dem weiteren Eingang 27 des Phasendetektors 18 angelegt wird. Diese Impulse werden mit den Impulsen an dem einen Eingang 26 des Phasendetektors 18 auf ihre gegenseitige Phasenlage verglichen, und am Ausgang des Phasendetektors 18 wird eine Impulsfolge erzeugt, deren Impulslänge der jeweiligen Phasendifferenz proportional ist. Die Impulse der Impulsfolge werden in dem Tiefpaß integriert, der demzufolge eine Spannung $U_{AR}$ erzeugt. Von dem Phase-locked loop-Schaltungsaufbau wird in einem Einschwingvorgang schließlich eine Frequenz $f_A$ am Ausgang 24 des spannungsgesteuerten Oszillators 1 erzeugt, die als entsprechende Impulsfolge auch an dem einen Eingang 26 des Phasendetektors 18 liegt. Im eingeschwungenen Zustand wird am Ausgang 20 des Tiefpasses 19 und damit als Eingangsspannung $U_E$ am Eingang des spannungsgesteuerten Oszillators 1 eine Spannung erzeugt, die den Oszillator 1 zur Abgabe einer Spannung mit der Ausgangsfrequenz $f_A$ veranlaßt, die genau der Frequenz $f_R$ am weiteren Eingang 27 des Phasendetektors 18 entspricht.

Anschließend wird zur Kalibrierung von dem Rechner 8, dem von dem Frequenz-Sollwertgeber 14 ein der Frequenz $f_R$ entsprechendes digitales Sollwertsignal zugeführt worden ist, über den Digital-Analog-Umsetzer an den Eingang 3 der Summierschaltung 2 eine Ausgangsspannung $U_D$ mit einer Größe abgegeben, die der Ausgangsspannung $U_{AR}$ des Tiefpasses 19 entspricht. Dies wird dadurch erreicht, daß die Ausgangsspannung des Tiefpasses 19 vom Fensterkomparator 23 überwacht wird, indem der Fensterkomparator 23 bei einem Wert Null der Ausgangsspannung $U_{AR}$ des Tiefpasses 19 ein entsprechendes Signal an den Rechner 8 abgibt, wodurch nicht nur die Spannung $U_D$ am Ausgang 4 des Digital-Analog-Umsetzers 5 festgehalten wird, sondern gleichzeitig ein dieser analogen Spannung entsprechender Digitalwert im nichtflüchtigen Speicher 12 eingespeichert wird. Da gleichzeitig die Frequenz $f_R$ des Frequenz-Sollwertgebers 14 im Rechner 8 gespeichert ist, ist in dem Rechner 8 also der Frequenz $f_R$ ein bestimmter Spannungswert $U_D$ in digitaler Form zugeordnet.

Dieser Vorgang läuft bei verschiedenen Frequenz-Sollwerten ab, so daß in dem Rechner 8 bei der Durchführung des erfindungsgemäßen Verfahrens eine Reihe von Werten gespeichert werden, die jeweils einem bestimmten Frequenz-Sollwert eine bestimmte Ausgangsspannung am Digital-Analog-Umsetzer 5 zuordnen. Zwischenwerte können gegebenenfalls durch Interpolation ermittelt werden. Danach kann die gesamte Kalibriereinrichtung 13 von dem Rechner 8 und dem spannungsgesteuerten Oszillator 1 abgetrennt werden, wodurch dann ein einstellbarer Frequenzgenerator gewonnen ist, der aus dem Rechner 8, dem Digital-Analog-Umsetzer 5 und dem spannungsgesteuerten Oszillator 1 besteht. Die Summierschaltung 2 kann entfallen, weil der Ausgang 4 des Digital-Analog-Umsetzers 5 direkt mit dem Eingang des spannungsgesteuerten Oszillators 1 verbunden werden kann. Auf diese Weise ist dann ein Frequenzgenerator gewonnen. der im Start-Stop-Betrieb arbeiten kann und somit auf eine an dem Rechner 8 vorgewählte Frequenz sofort ohne Einschwingverhalten am Ausgang 24 des spannungsgesteuerten Oszillators ein Signal mit der gewünschten Ausgansfrequenz $f_A$ erzeugt, wobei dieses Signal auch einer bestimmten Anfangsbedingung genügt, also beispielsweise mit einem Nulldurchgang von Minus nach Plus beginnt.

Wird die Kalibriereinrichtung 13 nach Beendigung des Kalibriervorganges nicht von den übrigen Teilen der Schaltungsanordnung nach Fig. 1 abgetrennt, dann erhält man einen einstellbaren Frequenzgenerator, der bei geschlossenem Schalter 21 im kontinuierlichen Betrieb arbeitet und bei geöffnetem Schalter 21 im Start-Stop-Betrieb benutzt werden kann.

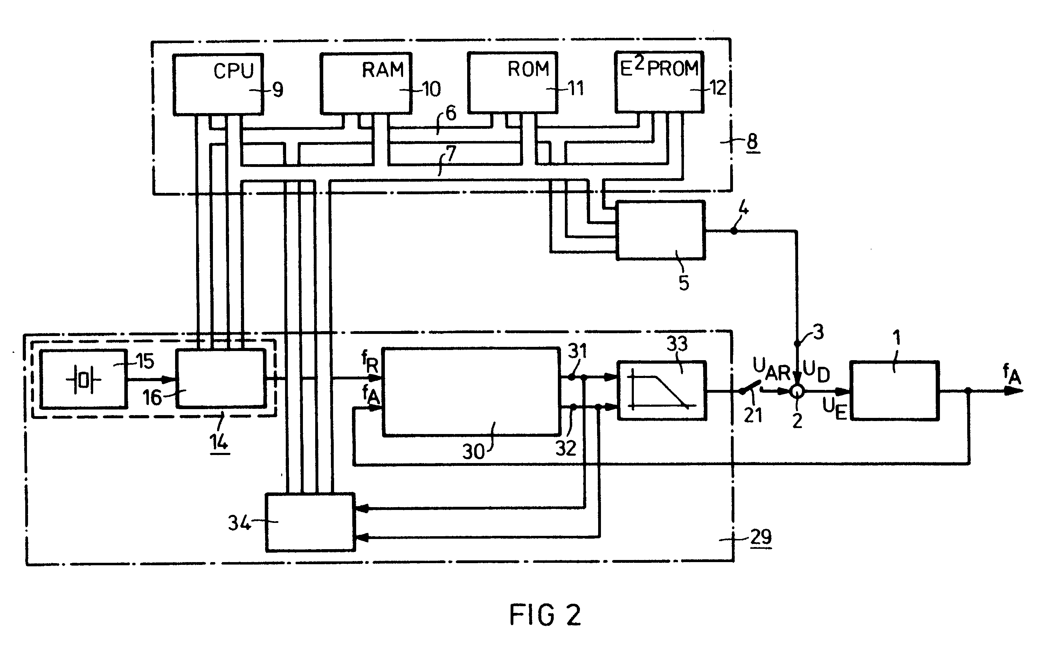

Die in Fig. 2 dargestellte Schaltungsanordnung stimmt in vielen Teilen mit der nach Fig. 1 überein, so daß übereinstimmende Teile in beiden Figuren mit gleichen Bezugszeichen versehen sind. Ein wesentlicher Unterschied der Schaltungsanordnung nach Fig. 2 zu der vorangehend beschriebenen besteht darin, daß sie in einer Kalibriereinrichtung 29 einen Phasendetektor 30 mit zwei Ausgängen enthält, wie er beispielsweise in dem Buch von Roland Best "Theorie und Anwendungen des Phase-locked Loops", 3. Auflage, 1982, Seite 16, letzte Zeile beschrieben ist. Der Phasendetektor 30 weist die beiden Ausgänge 31 und 32 auf, die einerseits mit einem nachgeordneten Tiefpaß 33 und andererseits mit einer digitalen Impuls-Überwachungseinrichtung 34 verbunden sind. Die digitale Impuls-Überwachungseinrichtung 34 ist ausgangsseitig mit dem Adreßbus 6 und dem Datenbus 7 des Rechners 8 verbunden. Der Tiefpaß 33 ist wiederum über einen Schalter 21 mit einer Summierschaltung 2 verbunden, die genauso wie bei der Schaltungsanordnung nach Fig. 1 mit den übrigen Bausteinen schaltungstechnisch verknüpft ist.

Bei der Herstellung eines einstellbaren Frequenzgenerators mit der Schaltungsanordnung nach Fig. 2 wird in ähnlicher Weise wie mit der Schaltungsanordnung nach Fig. 1 vorgegangen. Es wird hier im Unterschied lediglich mittels der digitalen Impuls-Überwachungseinrichtung 34 überwacht, ob an den Ausgängen 31 und 32 Signale anstehen, die gleiche Phasenlage aufweisen. Ist dies der Fall, dann gilt der jeweilige Kalibriereinzelvorgang als abgeschlossen, und es wird ein digitales Signal entsprechend der Spannung $U_D$ am Eingang 3 der Summierschaltung 2 im Rechner 8 dem jeweiligen Frequenz-Sollwert zugeordnet abgespeichert.

Durch Abtrennen der Kalibriereinrichtung 29 von dem Rechner 8 und dem spannungsgesteuerten Oszillator 1 läßt sich dann ein Frequenzgenerator gewinnen, der im Start-Stop-Betrieb eingesetzt werden kann. Wird die Kalibriereinrichtung 29 nicht abgetrennt, dann ergibt sich ein Frequenzgenerator, der in Abhängigkeit von der Schalterstellung des Schalters 21 sowohl als kontinuierlich arbeitender Frequenzgenerator als auch als Start-Stop-Frequenzgenerator eingesetzt werden kann.

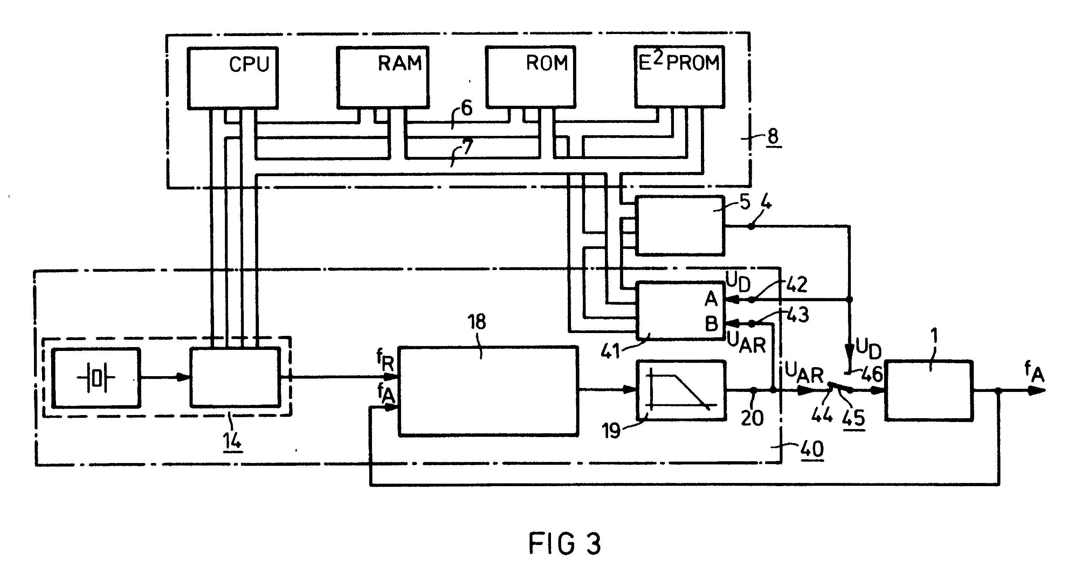

In der Schaltungsanordnung nach Fig. 3 enthält eine Kalibriereinrichtung 40 neben dem Frequenz-Sollwertgeber 14, dem diesem nachgeordneten Phasendetektor 18 und dem Tiefpaß 19 einen Komparator 41, dessen einer Eingang 42 mit dem Ausgang 4 des Digital-Analog-Umsetzers 5 verbunden ist. Ein weiterer Eingang 43 des Komparators 41 ist mit dem Ausgang 20 des Tiefpasses 19 verbunden. Der Ausgang 20 des Tiefpasses 19 ist außerdem an einen Kontakt 44 eines Schalters 45 herangeführt, der mit dem spannungsgesteuerten Oszillator 1 verbunden ist. Ein weiterer Kontakt 46 des Schalters 45 ist sowohl mit dem einen Eingang 42 des Komparators 41 als auch mit dem Ausgang 4 des Digital-Analog-Umsetzers 5 verbunden. Der Komparator 41 ist ausgangsseitig mit dem Adreßbus 6 und dem Datenbus 7 des Rechners 8 verbunden, der ebenso wie in den Figuren 1 und 2 dargestellt aufgebaut ist.

Der Kalibriervorgang läuft bei der Schaltungsanordnung nach Fig. 3 in der Weise ab, daß auf einen mittels des Frequenz-Sollwertgebers 14 eingestellten Frequenzwert hin von dem Rechner 8 mittels des Digital-Analog-Umsetzers 5 bei dargestellter Stellung des Schalters 45 eine Spannung $U_D$ erzeugt wird, die genauso groß ist wie die Spannung $U_{AR}$ am Ausgang des Tiefpasses 19. Die Gleichheit der Spannung $U_D$ und der Spannung $U_{AR}$ wird mittels des Komparators 41 festgestellt, der bei Spannungsgleichheit an seinem Ausgang ein Signal an den Rechner 8 abgibt, woraufhin in letzterem sowohl der gerade gewählte Frequenz-Sollwert als auch in digitaler Form der Spannungswert $U_D$ abgespeichert wird. Dies wird wiederum für eine Reihe von Frequenz-Sollwerten vorgenommen.

Ist der Kalibriervorgang abgeschlossen, dann kann durch Umlegen des Schalters 45 auf den Kontakt 46 die dargestellte Schaltungsanordnung im Start-Stop-Betrieb benutzt werden, wobei auf jeden vorgewählten Frequenzwert im Rechner 8 hin am Ausgang des spannungsgesteuerten Oszillators 1 sofort ohne jedes Einschwingverhalten eine Ausgangsfrequenz $f_A$ gebildet wird, die der gewünschten Frequenz entspricht. Liegt der Schalter 45 in der gezeigten Stellung, dann läßt sich die dargestellte Schaltungsanordnung als kontinuierlich arbeitender Frequenzgenerator benutzen.

## Ansprüche

1. Verfahren zum Kalibrieren eines einstellbaren Frequenzgenerators mit einem spannungsgesteuerten Oszillator (1), dem über einen Digital-Analog-Umsetzer (5) ein Rechner (8) vorgeordnet ist,
   **dadurch gekennzeichnet,**
   daß dem Oszillator (1) eine Kalibriereinrichtung (13) mit einer Reihenschaltung aus einem digitalen Phasendetektor (18) und einem Tiefpaß (19) unter Bildung eines Phase-locked loop-Schaltungsaufbaues vorgeordnet wird, indem der Ausgang (24) des Oszillators (1) mit einem Eingang (26) des Phasendetektors (18) und ein weiterer Eingang (27) des Phasendetektors (18) mit einem einstellbaren Frequenz-Sollwertgeber (14) der Kalibriereinrichtung (13) verbunden werden, daß dem Rechner (8) digitale Sollwertsignale entsprechend verschiedenen Frequenz-Sollwertsignalen an dem weiteren Eingang (27) des Phasendetektors (18) zugeführt werden, daß von dem Rechner (8) nach Erreichen des eingeschwungenen Zustandes des Phase-locked loop-Schaltungsaufbaues auf das jeweilige Frequenz-Sollwertsignal hin die Ausgangsspannung des Digital-Analog-Umsetzers (5) als Steuerspannung ($U_D$) für den Oszillator (1) geändert wird, bis sie der Ausgangsspannung ($U_{AR}$) des Tiefpasses (19) vor Beginn des Kalibriervorganges entspricht, daß ein der Steuerspannung ($U_D$) entsprechender Digitalwert dem jeweiligen digitalen Sollwertsignal zugeordnet im Rechner (8) gespeichert wird und daß der Eingang des Oszillators (1) unter Bildung des einstellbaren Frequenzgenerators von der Kalibriereinrichtung (13) abgetrennt wird.

2. Verfahren nach Anspruch 1,
   **dadurch gekennzeichnet,**
   daß der Ausgang (4) des Digital-Analog-Umsetzers (5) über eine Summierschaltung (2) mit dem Eingang des spannungsgesteuerten Oszillators (1) verbunden wird, daß die Ausgangsspannung ($U_{AR}$) des Tiefpasses (19) auf das Erreichen des Wertes Null überwacht wird und daß beim Wert Null ein Speicherbefehl für das jeweilige digitale Sollwertsignal und den der Steuerspannung ($U_D$) entsprechenden Digitalwert erzeugt wird.

3. Verfahren nach Anspruch 1, **dadurch gekennzeichnet,**
   daß der Ausgang (4) des Digital-Analog-Umsetzers (5) über eine Summierschaltung (2) mit dem Eingang des spannungsgesteuerten Oszillators (1) verbunden wird, daß eine Kalibriereinrichtung (29) mit einem Phasendetektor (30) mit zwei Ausgängen verwendet wird, dessen beiden Ausgangssignale auf Phasengleichheit untersucht werden, und daß bei Phasengleichheit ein Speicherbefehl für das digitale Sollwertsignal und den der Steuerspannung ($U_D$) entsprechenden Digitalwert erzeugt wird.

4. Verfahren nach Anspruch 1, **dadurch gekennzeichnet,**
   daß der Ausgang (4) des Digital-Analog-Umsetzers (5) mit einem nicht belegten Kontakt (46) eines Schalters (45) verbunden wird, dessen weiterer belegter Kontakt (44) den spannungsgesteuerten Oszillator (1) mit dem Tiefpaß (19) verbindet, daß in dem eingeschwungenen Zustand die Ausgangsspannung ($U_D$) des Digital-Analog-Umsetzers (5) mit der Ausgangsspannung ($U_{AR}$) des Tiefpasses (19) verglichen und bei Spannungsgleichheit als die Steuerspannung ($U_D$) erkannt wird und daß bei Spannungsgleichheit ein Speicherbefehl für das digitale Sollwertsignal und den der Steuerspannung ($U_D$) entsprechenden Digitalwert erzeugt wird.

5. Schaltungsanordnung zur Durchführung des Verfahrens nach Anspruch 2, **dadurch gekennzeichnet,**
daß der Frequenz-Sollwertgeber (14) einerseits mit einem Adreß (6)- und einem Datenbus (7) des Rechners (8) und andererseits mit dem weiteren Eingang (27) des Phasendetektors (18) verbunden ist, daß eine Spannungsüberwachungs-Schaltung (23) der Kalibriereinrichtung (13) eingangsseitig mit dem Ausgang (20) des Tiefpasses (19) und ausgangsseitig mit dem Adreß (6)- und dem Datenbus (7) des Rechners (8) verbunden ist und daß der Digital-Analog-Umsetzer (5) eingangsseitig an dem Adreß (6)- und dem Datenbus (7) des Rechners (8) und ausgangsseitig mit der Summierschaltung (2) verbunden ist.

6. Schaltungsanordnung zur Durchführung des Verfahrens nach Anspruch 3, **dadurch gekennzeichnet,**
daß der Frequenz-Sollwertgeber (14) einerseits mit einem Adreß (6)- und einem Datenbus (7) des Rechners (8) und andererseits mit dem weiteren Eingang des Phasendetektors (30) verbunden ist, daß an den Ausgängen (31,32) des Phasendetektors (30) eingangsseitig eine digitale Impuls-Überwachungseinrichtung (34) der Kalibriereinrichtung (29) angeschlossen ist, die ausgangsseitig mit dem Adreß(6)- und dem Datenbus (7) des Rechners (8) verbunden ist und
daß der Digital-Analog-Umsetzer (5) eingangsseitig an dem Adreß (6)-und dem Datenbus (7) des Rechners (8) und ausgangsseitig mit der Summierschaltung (2) verbunden ist.

7. Schaltungsanordnung nach Anspruch 5 oder 6, **dadurch gekennzeichnet,**
daß die Summierschaltung (2) über einen Schalter (21) mit dem Ausgang des Tiefpasses (19; 33) verbindbar ist.

8. Schaltungsanordnung zur Durchführung des Verfahrens nach Anspruch 4, **dadurch gekennzeichnet,**
daß der Frequenz-Sollwertgeber (14) einerseits mit einem Adreß (6)- und einem Datenbus (7) des Rechners (8) und andererseits mit dem weiteren Eingang des Phasendetektors (18) verbunden ist, daß der Digital-Analog-Umsetzer (5) eingangsseitig an dem Adreß (6)- und dem Datenbus (7) des Rechners (8) und ausgangsseitig über den Schalter (45) an dem Eingang des der Kalibriereinrichtung (40) nachgeordneten Oszillators (1) angeschlossen ist und daß ein Komparator (41) der Kalibriereinrichtung (40) eingangsseitig sowohl mit dem Ausgang (4) des Digital-Analog-Umsetzers (5) als auch mit dem Ausgang (20) des Tiefpasses (19) und ausgangsseitig mit dem Adreß (6) -und Datenbus (7) des Rechners (8) verbunden ist.

9. Schaltungsanordnung nach Anspruch 8, **dadurch gekennzeichnet,**
daß der Oszillator (1) über den Schalter (45) mit dem Ausgang der Kalibriereinrichtung (13) verbindbar ist.

## Claims

1. Method for calibrating an adjustable frequency generator having a voltage-controlled oscillator (1) on the input side of which a computer (8) is arranged by way of a digital-to-analog converter (5), characterised in that there is arranged before the oscillator (1) a calibrating device (13) having a series circuit arrangement consisting of a digital phase detector (18) and a low-pass filter (19) thus forming a phase-locked-loop circuit arrangement, while the output (24) of the oscillator (1) is connected to one input (26) of the phase detector (18), and a further input (27) of the phase detector (18) is connected to an adjustable frequency-rated value transmitter (14) of the calibrating device (13), in that digital rated value signals are fed to the computer (8) in accordance with various frequency-rated value signals at the further input (27) of the phase detector (18), in that the output voltage of the digital-to-analog converter (5) as control voltage ($U_D$) for the oscillator (1) is varied by the computer (8) after the steady-state condition of the phase-locked-loop circuit arrangement has been reached in response to the respective frequency rated value signal, until it corresponds to the output voltage ($U_{AR}$) of the low-pass filter (19) before the start of the calibrating process, in that a digital value corresponding to the control voltage ($U_D$), associated with the respective digital rated value signal, is stored in the computer (8) and in that the input of the oscillator (1) is isolated from the calibrating device (13) thus forming the adjustable frequency generator.

2. Method according to claim 1, characterised in that the output (4) of the digital-to-analog converter (5) is connected, by way of a summing circuit arrangement (2), with the input of the voltage-controlled oscillator (1), in that the output voltage ($U_{AR}$) of the low-pass filter (19) is monitored for the attainment of the value zero and in that, in the case of the value zero, a memory command is generated for the respective digital rated value signal and the digital value corresponding to the control voltage ($U_D$).

3.  Method according to claim 1, characterised in that the output (4) of the digital-to-analog converter (5) is connected by way of a summing circuit arrangement (2) with the input of the voltage-controlled oscillator (1), in that a calibrating device (29) is used with a phase detector (30) having two outputs, the two output signals of which are investigated for phase coincidence and in that, in the case of phase coincidence, a memory command is generated for the digital rated value signal and the digital value corresponding to the control voltage ($U_D$).

4.  Method according to claim 1, characterised in that the output (4) of the digital-to-analog converter (5) is connected to an unused contact (46) of a switch (45), the further used contact (44) of which connects the voltage-controlled oscillator (1) with the low-pass filter (19), in that, in the steady-state condition the output voltage ($U_D$) of the digital-to-analog converter (5) is compared with the output voltage ($U_{AR}$) of the low-pass filter (19) and in the case of voltage equality is identified as the control voltage ($U_D$), and in that in the case of voltage equality, a memory command is generated for the digital rated value signal and the digital value corresponding to the control voltage ($U_D$).

5.  Circuit arrangement for carrying out the method according to claim 2, characterised in that the frequency rated value transmitter (14) is connected, on the one hand, with an address bus (6) and a data bus (7) of the computer (8) and, on the other hand, with the further input (27) of the phase detector (18), in that a voltage-monitoring circuit arrangement (23) of the calibrating device (13) is connected, on the input side, with the output (20) of the low-pass filter (19) and, on the output side, with the address bus (6) and the data bus (7) of the computer (8) and in that the digital-to-analog converter (5) is connected, on the input side, to the address bus (6) and the data bus (7) of the computer (8) and, on the output side, to the summing circuit arrangement (2).

6.  Circuit arrangement for carrying out the method according to claim 3, characterised in that the frequency rated value transmitter (14) is connected, on the one hand, to an address bus (6) and a data bus (7) of the computer (8) and, on the other hand, to the further input of the phase detector (30), in that a digital pulse-monitoring device (34) of the calibrating device (29) is connected, on the input side, to the outputs (31, 32) of the phase detector (30), which digital pulse-monitoring device (34) is connected, on the output side, to the address bus (6) and the data bus (7) of the computer (8), and in that the digital-analog-converter (5) is connected, on the input side, to the address bus (6) and the data bus (7) of the computer (8) and, on the output side, to the summing circuit arrangement (2).

7.  Circuit arrangement according to claim 5 or 6, characterised in that the summing circuit arrangement (2) can be connected to the output of the low-pass filter (19; 33) by way of a switch (21).

8.  Circuit arrangement for carrying out the method according to claim 4, characterised in that the frequency rated value transmitter (14) is connected, on the one hand, to an address bus (6) and a data bus (7) of the computer (8) and, on the other hand, to the further input of the phase detector (18), in that the digital-to-analog converter (5) is connected, on the input side, to the address bus (6) and the data bus (7) of the computer (8) and, on the output side, by way of the switch (45) to the input of the oscillator (1) which is arranged on the output side of the calibrating device (40) and in that a comparator (41) of the calibrating device (40) is connected, on the input side, both to the output (4) of the digital-to-analog converter (5) and to the output (20) of the low-pass filter (19) and, on the output side, to the address bus (6) and data bus (7) of the computer (8).

9.  Circuit arrangement according to claim 8, characterised in that the oscillator (1) can be connected to the output of the calibrating device (13) by way of the switch (45).

**Revendications**

1.  Procédé pour calibrer un générateur de fréquence réglable comportant un oscillateur (1) commandé par la tension, en amont duquel un ordinateur (8) est branché par l'intermédiaire d'un convertisseur numérique/analogique (5), caractérisé par le fait
    qu'en amont de l'oscillateur (1) est branché un dispositif de calibrage (13) comportant un circuit série formé d'un détecteur de phase numérique (18) et d'un filtre passe-bas (19) en formant une structure de circuit Phased-locked-loop, par le fait que la sortie (24) de l'oscillateur (1) est reliée à une entrée (26) du détecteur de phase (18) et qu'une autre entrée (27) du détecteur de phase (18) est reliée à un générateur réglable de valeurs de consigne à la fréquence (14) du dispositif de calibrage (13), qu'à l'ordinateur (8) sont envoyés des signaux de valeurs de consigne en fonction de différents signaux de valeurs de consigne de la fréquence présents sur l'autre entrée (27) du détecteur de phase (18), que lorsque la structure de circuit Phased-locked-loop a atteint l'état stationnaire, la tension de sortie du convertisseur numérique/analogique (5) est modifiée par l'ordinateur (8) en tant que tension de commande ($U_D$) pour l'oscillateur (1), lors de l'apparition du signal respectif de la valeur de consigne de la fréquence, jusqu'à ce que ladite tension corresponde à la tension de sortie ($U_{AR}$) du filtre passe-bas (19) avant le début de l'opération de calibrage, qu'une valeur numérique correspondant à la tension de commande ($U_D$) est mémorisée dans l'ordinateur (8) en étant associée au signal numérique respectif de la valeur de consigne, et que l'entrée de l'oscillateur (1) est séparée du dispositif de calibrage (13), tout en formant le générateur réglable de fréquence.

2. Procédé selon la revendication 1, caractérisé par le fait que la sortie (4) du convertisseur numérique/analogique (5) est reliée par l'intermédiaire d'un circuit de sommation (2) à l'entrée de l'oscillateur (1) commandé par la tension, que la tension de sortie ($U_{AR}$) du filtre passe-bas (19) est contrôlée afin de savoir si elle atteint la valeur zéro, et que pour la valeur zéro, une instruction de mémorisation est produite pour le signal numérique de la valeur de consigne et pour la valeur numérique correspondant à la tension de commande ($U_D$).

3. Procédé suivant la revendication 1, caractérisé par le fait que la sortie (4) du convertisseur numérique/analogique (5) est reliée par l'intermédiaire d'un circuit de sommation (2) à l'entrée de l'oscillateur (1) commandé par la tension, qu'on utilise un dispositif de calibrage (29) possédant un détecteur de phase (30) comportant deux sorties, dont les deux signaux sont examinés pour déterminer s'ils possèdent une même phase, et

qu'en cas d'égalité de phase, un signal de mémorisation est produit pour le signal numérique de la valeur de consigne et pour la valeur numérique correspondant à la tension de commande ($U_D$).

4. Procédé suivant la revendication 1, caractérisé par le fait que la sortie (4) du convertisseur numérique/analogique (5) est reliée à un contact non occupé (46) d'un commutateur (45), dont l'autre contact occupé (44) relie l'oscillateur (1) commandé par la tension au filtre passe-bas (19), qu'à l'état stationnaire, la tension de sortie ($U_D$) du convertisseur numérique/analogique (5) est comparée à la tension de sortie ($U_{AR}$) du filtre passe-bas (19) et est identifiée en tant que tension de commande ($U_D$), en cas d'égalité entre ces tensions, et qu'en cas d'égalité des tensions, une instruction de mémorisation est produite pour le signal numérique de la valeur de consigne et pour la valeur numérique correspondant à la tension de commande ($U_D$).

5. Montage pour la mise en oeuvre du procédé suivant la revendication 2, caractérisé par le fait que le générateur (14) de la valeur de consigne de la fréquence est raccordé d'une part à un bus (6) de transmission d'adresses et à un bus (7) de transmission de données à l'ordinateur (8) et d'autre part à l'autre entrée (27) du détecteur de phase (18), qu'un circuit de contrôle de la tension (23) du dispositif de calibrage (13) est raccordé, côté entrée, à la sortie (20) du filtre passe-bas (19) et, côté sortie, au bus (6) de transmission d'adresses et au bus (7) de transmission de données de l'ordinateur (8), et que le convertisseur numérique/analogique (5) est relié, côté entrée, au bus (6) de transmission d'adresses et au bus (7) de transmission de données de l'ordinateur (8) et, côté sortie, au circuit de sommation (2).

6. Montage pour la mise en oeuvre du procédé suivant la revendication 3, caractérisé par le fait que le générateur (14) de la valeur de consigne de la fréquence est raccordé d'une part à un bus (6) de transmission d'adresses et à un bus (7) de transmission de données de l'ordinateur (8) et d'autre part à une autre entrée du détecteur de phase (30), qu'aux sorties (31,32) du détecteur de phase (30) est raccordé, sur le côté entrée, un dispositif numérique de contrôle d'impulsions (34) du dispositif de calibrage (29), qui est raccordé, côté

9

sortie, au bus (6) de transmission d'adresses et au bus (7) de transmission d'adresses de l'ordinateur (8), et

que le convertisseur numérique/analogique (5) est raccordé, côté entrée, au bus (6) de transmission d'adresses et au bus (7) de transmission de données de l'ordinateur (8) et, côté sortie, au circuit de sommation (2).

7. Montage suivant la revendication 5 ou 6, caractérisé par le fait que le circuit de sommation (2) est susceptible d'être relié à la sortie du filtre passe-bas (19;33) par l'intermédiaire d'un interrupteur (21).

8. Montage pour la mise en oeuvre du procédé suivant la revendication 4, caractérisé par le fait que le générateur (14) de la valeur de consigne de la fréquence est raccordé d'une part à un bus (6) de transmission d'adresses et à un bus (7) de transmission de données de l'ordinateur (8) et d'autre part à une autre entrée du détecteur de phase (18), que le convertisseur numérique/analogique (5) est raccordé, côté entrée, au bus (6) de transmission d'adresses et au bus (7) de transmission de données de l'ordinateur (8) et côté sortie, au moyen du commutateur (45), à l'entrée de l'oscillateur (1) branché en aval du dispositif de calibrage (40), et qu'un comparateur (41) du dispositif de calibrage (40) est raccordé, côté entrée, aussi bien à la sortie qu'à l'entrée du convertisseur numérique/analogique (5) et à la sortie (20) du filtre passe-bas (19), et, côté sortie, au bus (6) de transmission d'adresses et au bus (7) de transmission de données de l'ordinateur (8).

9. Montage suivant la revendication 8, caractérisé par le fait que l'oscillateur (1) est susceptible d'être relié par l'intermédiaire du commutateur (45) à la sortie du dispositif de calibrage (13).

FIG 1

EP 0 210 124 B1

FIG 2

EP 0 210 124 B1

FIG 3

EP 0 210 124 B1